# EUROPEAN PATENT SPECIFICATION

(11) **EP 2 586 745 B1**
(45) Date of publication and mention of the grant of the patent: **11.02.2015**
(21) Application number: 12189698.9
(22) Date of filing: 24.10.2012
(51) Int. Cl.: C01B 33/037, C30B 29/06, C30B 11/00, H01L 31/18, B01J 3/00

(54) **A vacuum recycling apparatus and method for refining solar grade polysilicon**
Vakuum-Wiedergewinnungsvorrichtung und Verfahren zum Raffinieren von Solarsilizium
Appareil de recyclage sous vide et procédé de raffinage de polysilicium de qualité solaire

(30) Priority: 24.10.2011 TW 100138537; 20.01.2012 TW 101102333
(43) Date of publication of application: 01.05.2013
(73) Proprietor: Sun, Wen-Pin, 407 Taichung City (TW); Huang, Hsiu-Min, 114 Taipei City (TW)
(72) Inventor: Sun, Wen-Pin, 407 Taichung City (TW)
(74) Representative: Horak, Michael

(56) References cited:
- JP-A- 2003 002 629
- US-A- 5 961 944
- US-A1- 2011 114 012

## Description

### (a) Technical Field of the Invention

The present invention generally relates to solar cells, and especially relates to a USB female connector immune from the crosstalk problem resulted from high-frequency signal.

### (b) Description of the Prior Art

There are two major applications to polysilicon material. One application is for the production of solar cells. The other application is for integrated circuits. The two applications have different requirements to polysilicon material. The electronic grade polysilicon is required to have its purity between 9N and 11N whereas the solar grade polysilicon is required to have a less purity between 5N and 7N for achieving sufficient photoelectric conversion efficiency and life span.

The electronic grade polysilicon is usually produced by a high-cost chemical method which is improved from the original Siemens method. The solar grade polysilicon on the other hand can be produced by a certain physical method for reduced cost. In addition to the improved Siemens methods, there are metallurgical method, dilution method, and fluidized bed method, etc.

As the solar grade polysilicon is not required to have high purity, highly pure polysilicon has to be appropriately doped by boron and phosphorus to reduce its purity for photovoltaic purpose. This not only is ironic but also causes a high cost.

RH vacuum process, or vacuum recycling process, is taught jointly by two German companies: Ruhrstahl and Heraeus. The process submerges two pipes of a vacuum chamber into molten steel, and vacuums the chamber to raise the molten steel to a specific level. Then, by driving inert gas into an input pipe to force molten steel into the vacuum chamber for vacuum processing, the molten steel then flow back into the container through an output pipe. This process is conventionally applied in a steel factory for vacuuming processing molten steel. The present inventor has taught a metallurgical method for refining polysilicon in a Taiwan patent application numbered 099136030 and filed on 2010/10/22. The teaching uses a RH device to remove boron and phosphorous. However, some residual of molten steel is accumulated at corners of the input and output pipes, leading to inferior circulation of the molten steel and the product's purity.

US 2011/114012 A1 relates to an apparatus with a vacuum chamber, a container for molten silicon, a plasma gun and a tube to introduce inert gas in the silicon container. It also relates to a process to purify silicon by melting silicon in the container, removing impurities via a vacuum, subsequently supplying (inert) gases towards the surface of the silicon melt. The silicon is allowed to melt to efficiently circulate inside crucible. Plasma and gases are intermittently provided during the process. Impurities are removed with directional cooling.

In this document, the inert gases do not pass through the molten silicon, nor vacuum is created in the two chambers.

US 5 961 944 A relates to a method for purifying silicon by melting metallic silicon under vacuum to remove the phosphorus contained therein by evaporation, and then carrying out solidification. The silicon is melted again using plasma and simultaneously blowing argon or a mixture of argon and hydrogen into the melt. The so-obtained silicon is cast in a mold, followed by solidification to obtain a ingot; and removing the impurity concentrated portion by cutting.

### SUMMARY OF THE INVENTION

In order to overcome the above problems of the prior arts, the present invention provides a vacuum recycling apparatus and a method for refining solar grade polysilicon. The present invention is able to directly produce solar grade polysilicon with a specified purity. For example, the produced polysilicon would have solar grade purity between 5N and 7N. The present invention does not produce polysilicon of a greater-than-7N purity and requires the addition of impurities such as boron and phosphorous so as to lower its purity. The present invention therefore can greatly reduce production time and cost. In addition, the present invention does not rely on input and output pipes and as such obviates the problem of residual solution.

To achieve the above objectives, is provided which contains a vacuum degassing (VD) device and a vacuum recycling (RH) device. The VD device contains a vacuum chamber, a silicon-stored bucket, a plasma gun, and an inert gas introduction device. The vacuum chamber contains a first degassing outlet and a joining opening. The silicon-stored bucket is positioned in the vacuum chamber and beneath the joining opening for storing liquid silicon solution or for storing solid silicon. The plasma gun is operable to remove impurities of the silicon solution in the silicon-stored bucket. The inert gas introduction device is configured in the silicon-stored bucket. The RH device contains a second degassing outlet and a connection pipe. The connection pipe is plugged into the silicon-stored bucket through the joining opening. The joining opening is then tightly sealed so that introduced inert gas by the inert gas introduction device moves towards the connection pipe. By vacuuming the VD device and the RH device through the first and second degassing outlets, respectively, and by adjusting the degrees of vacuum of the VD device and the RH device, the height of the liquid silicon solution in the RH device is controlled.

The vacuum recycling apparatus is able to directly produce polysilicon of a specified purity, significantly saving production time and cost.

Preferably, the VD device is integrated with a furnace into a single device so as to reduce thermal loss and to enhance heating efficiency.

Preferably, the silicon-stored bucket is integrated into the VD device as an integral chamber so as to reduce the dimension of the VD device.

Preferably, the silicon-stored bucket is integrated into the VD device as an integral chamber; and the VD device is further integrated with a furnace into a single device.

Preferably, the degrees of the vacuum of the vacuum chamber of the VD device and the RH device are between 0.1 to 0.9 atm, and between 0.001 to 1,000 Pa, respectively.

Preferably the RH device further contains a real-time measuring device so as to measure and monitor the amount of impurities in the silicon solution in the silicon-stored bucket.

The present invention further provides a method of applying the vacuum recycling apparatus to refine solar grade polysilicon. The method contains (a) a liquefaction step; (b) a vacuuming step; (c) a stir step; (d) an impurity removal step; (e) a confirmation step; and (f) a formation step. The method can directly produce solar grade polysilicon of a specified purity with reduced production time and cost compared to the prior arts.

Preferably, the confirmation step disrupts the supply of the inert gas when the amount of phosphorous in the silicon solution is less than 0.8 ppm and the amount of boron in the silicon solution is less than 0.4 ppm, so as to precisely control the amount of impurities.

Preferably, the formation step crushes the solidified silicon solution into 50 to 150 meshes for better acid-cleaning.

The foregoing objectives and summary provide only a brief introduction to the present invention. To fully appreciate these and other objects of the present invention as well as the invention itself, all of which will become apparent to those skilled in the art, the following detailed description of the invention and the claims should be read in conjunction with the accompanying drawings. Throughout the specification and drawings identical reference numerals refer to identical or similar parts.

Many other advantages and features of the present invention will become manifest to those versed in the art upon making reference to the detailed description and the accompanying sheets of drawings in which a preferred structural embodiment incorporating the principles of the present invention is shown by way of illustrative example.

### BRIEF DESCRIPTION OF THE DRAWINGS

FIG 1 is a sectional diagram showing a vacuum recycling apparatus for refining solar grade polysilicon according an embodiment of the present invention.
FIG. 2 is a sectional diagram showing the vacuum recycling apparatus of FIG 1 joined to a silicon-stored steel bucket.
FIG 3 is a flow diagram showing the steps of refining solar grade polysilicon using the vacuum recycling apparatus of FIG. 1.

### DETAILED DESCRIPTION OF THE PREFERRED EMBODIMENTS

The following descriptions are exemplary embodiments only, and are not intended to limit the scope, applicability or configuration of the invention in any way. Rather, the following description provides a convenient illustration for implementing exemplary embodiments of the invention. Various changes to the described embodiments may be made in the function and arrangement of the elements described without departing from the scope of the invention as set forth in the appended claims.

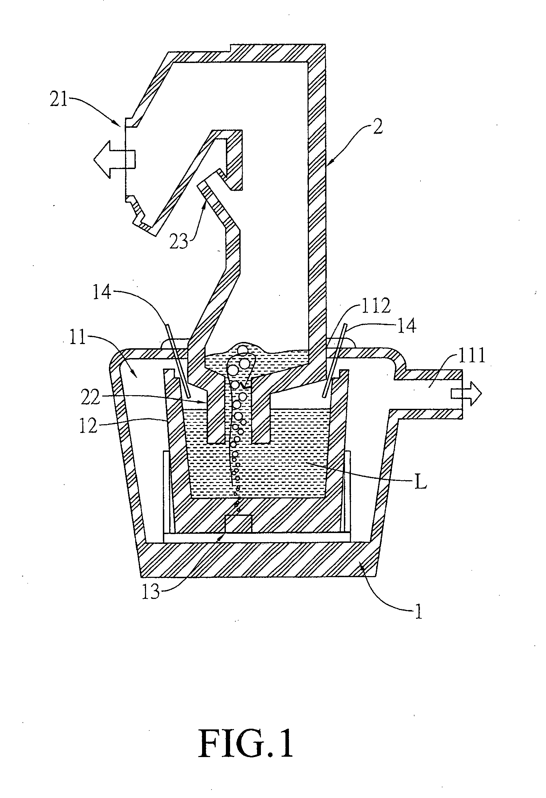

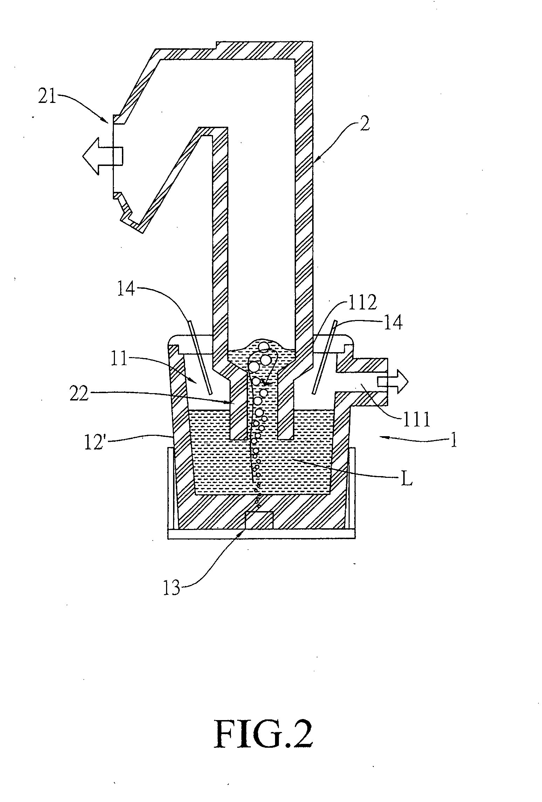

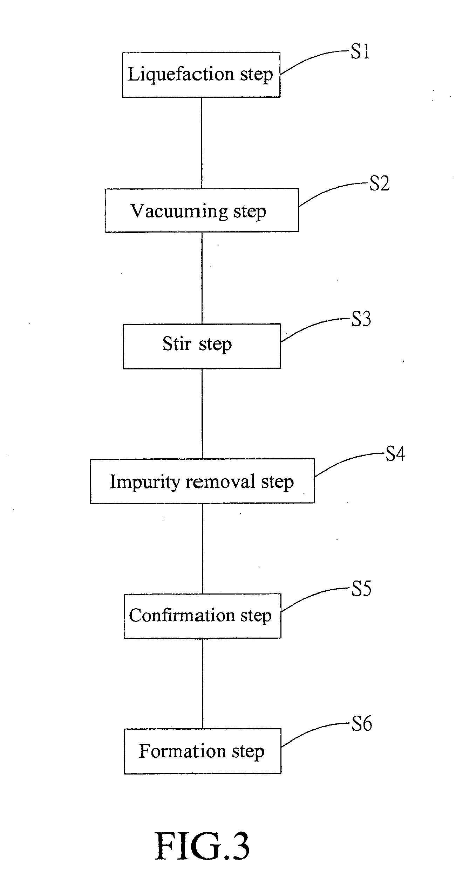

FIG 1 is a sectional diagram showing a vacuum recycling apparatus for refining solar grade polysilicon according an embodiment of the present invention. FIG 2 is a sectional diagram showing the vacuum recycling apparatus joined to a silicon-stored steel bucket. FIG 3 is a flow diagram showing the steps of refining solar grade polysilicon using the vacuum recycling apparatus of FIG 1. As shown in FIG 1, the vacuum recycling apparatus contains a vacuum degassing (VD) device 1 and a vacuum recycling device 2 (i.e., a RH device).

The VD device 1 contains a vacuum chamber 11, a silicon-stored bucket 12, and an inert gas introduction device 13. The vacuum chamber 11 contains a first degassing outlet 111 and a joining opening 112. The silicon-stored bucket 12 is positioned in the vacuum chamber 11 and beneath the joining opening 112 for storing liquid silicon solution L or for storing solid silicon. The inert gas introduction device 13 is configured in the silicon-stored bucket 12 so that inert gas can be introduced into the silicon-stored bucket 12.

The RH device 2 contains a second degassing outlet 21 and a connection pipe 22. The connection pipe 22 is plugged into the silicon-stored bucket 12 through the joining opening 112. The joining opening 112 is then tightly sealed so that the introduced inert gas by the inert gas introduction device 13 moves towards the connection pipe 22. By vacuuming the VD device 1 and the RH device 2 through the first and second degassing outlets 111 and 21, respectively, as indicated by the arrows in the drawings, and by adjusting the degrees of vacuum of the VD device 1 and the RH device 2, the height of the liquid silicon solution L in the RH device 2 can be controlled.

Through the vacuum recycling apparatus described above, the process of refining polysilicon requires a less amount of time, thereby leading to a reduced cost. More details will be given later.

Furthermore, the VD device 1 can be further integrated with a furnace into a single device to facilitate heating and to prevent thermal loss, so as to achieve superior heating efficiency. As the integration of the VD device 1 and the furnace should be straightforward to those of related arts, and the integration result is close to what is shown in FIG 1, the details are omitted here.

In addition, the RH device 2 is configured with a real-time measuring device 23 so as to measure and monitor the amount of impurities in the silicon solution L in the silicon-stored bucket 12.Plasma guns 14 are configured in the VD device 1 so as to remove the impurities of the silicon solution L in the silicon-stored bucket 12.

As shown in FIG 2, the silicon-stored bucket 12 can be integrated into the VD device 1 as an integral chamber 12' so as to improve efficiency and to reduce the dimension of the VD device 1.

The above-mentioned furnace can be a medium frequency furnace.

More specifically, to refine solar grade polysilicon, the degrees of the vacuum of the vacuum chamber 11 of the VD device 1 and the RH device are between 0.1 to 0.9 atm, and between 0.001 to 1,000 Pa, respectively.

A method of applying the vacuum recycling apparatus to refine solar grade polysilicon contains (a) a liquefaction step S1, (b) a vacuuming step S2, (c) a stir step S3, (d) an impurity removal step S4, (e) a confirmation step S5, and (f) a formation step S6. The details of these steps are as follows.

The liquefaction step S1 liquefies and pours silicon raw material into the silicon-stored bucket 12 until the silicon solution L has a level higher than the aperture of the connection pipe 22.

The vacuuming step S2 degasses the VD device 1 and the RH device 2 until their degrees of the vacuum are between 0.1 to 0.9 atm, and between 0.001 to 1,000 Pa, respectively.

The stir step S3 agitates the silicon solution L by introducing inert gas through the inert gas introduction device 13 and, as the inert gas moves towards the connection pipe 22, achieves diffusing and degassing effects.

The impurity removal step S4 uses the plasma guns 14 to remove impurities.

The confirmation step S5 disrupts the supply of the inert gas when the amount of boron in the silicon solution L is less than 0.4 ppm, and the amount of phosphorous is less than 0.8 ppm. The degree of vacuum in the RH device 2 is also reduced so that the silicon solution L flows back into the silicon-stored bucket 12.

The formation step S6 pours the silicon solution L processed by the above steps into a slow-condensing container. After cooling, the less pure offcuts are removed and the solidified silicon is crushed, acid-cleaned for removing impurities, and then casted into directional ingot. Solar grade polysilicon is as such produced.

Unlike the prior arts where impurities are first removed and then added so as to achieve solar grade polysilicon, the present invention is able to achieve a shorter process time and a lower production cost.

In the formation step S6, the solidified silicon solution is crushed into 50 to 150 meshes so as to facilitate the subsequent acid-cleaning.

To facilitate the understanding of the present method, together with FIG 1, an embodiment of the above steps is described as follows,

Firstly, solid 2N to 4N metallic silicon raw material is heated into liquid metallic silicon solution L and then poured into the silicon-stored bucket 12.

Secondly, the silicon-stored bucket 12 is positioned in the vacuum chamber 11 and heated (about 1,000 to 1,800°C) so as to maintain the high-temperature, liquid metallic silicon solution state.

Thirdly, the connection pipe 22 of the RH device 2 is plugged into the silicon-stored bucket 12 in the vacuum chamber 11 of the VD device 1 and submerged into the liquid silicon solution L.

Fourthly, the VD device 1 and the RH device 2 are sealed tightly and vacuumed so that their degrees of vacuum are between 0.1 to 0.9 atm, and between 0.001 to 1,000 Pa, respectively. Inert gas such as Ar, He, or N₂, is introduced into the connection pipe 22.

Fifthly, the inert gas produces bubbles in the silicon solution L as shown in the drawings. Then, through the control of degree of vacuum and therefore the level of the liquid silicon solution L and the stir of the liquid silicon solution L by the bubbles, the impurities such as Fe, Al, Ca, C, O, P, B, etc., can be effectively removed and highly pure polysilicon can be obtained.

Sixthly, the silicon solution L is heated (or kept at a temperature) by configuring electronic beam or plasma guns on the VD device. Then, boron (B) is removed and Ar, H₂O vapor, H₂ are added.

Seventhly, after the recycling, diffusion, and degassing for a period of time (about 10 minutes to 10 hours), the provision of the inert gas is disrupted when the real-time measuring device 23 detects that the amount of boron is less than 0.4 ppm and phosphorous is less than 0.8 ppm. Then, the degree of vacuum in the RH device 2 is reduced and the liquid silicon solution L flows back into the silicon-stored bucket 12 in the VD device 1.

Eighthly, the highly pure (4N to 6N), degassed, de-boron, and de-phosphorus polysilicon solution L in the silicon-stored bucket 12 is poured into the slow-condensing container. After cooling for a long period of time (4 to 72 hours), the less pure offcuts are removed and the solidified silicon is crushed into 50 to 150 meshes, acid-cleaned for removing impurities such as Fe, Al, and Ca, etc., and then casted into directional ingot. Highly pure (6N to 7N) solar grade polysilicon (UMG-Si) is as such produced, and can be directly cut for the production of solar cells.

In alternative embodiments, the VF device 1 can be integrated with a medium frequency furnace into a single device. As such, solid silicon can be directly heated (1,000 to 1,800 °C) through the medium frequency furnace in the VD device 1 into high-temperature liquid silicon solution L. Alternatively, as shown in FIG 2, the silicon-stored bucket 12 can be integrated into the VD device 1 as an integral chamber 12'. Furthermore, the VD device 1, the medium frequency furnace, and the silicon-stored bucket 12 can be integrated together so as to reduce the time and effort to transfer material between these devise.

## Claims

1. A vacuum recycling apparatus for refining solar grade polysilicon, comprising a vacuum degassing (VD) device 1 and a vacuum recycling (RH) device 2, wherein
the VD device 1 comprises a vacuum chamber 11, a silicon-stored
bucket 12, a plasma gun 14, and an inert gas introduction device 13;
the vacuum chamber 11 comprises a first degassing outlet 111 and a
joining opening 112;
the silicon-stored bucket 12 is positioned in the vacuum chamber 11
and beneath the joining opening 112 for storing liquid silicon solution L or for storing solid silicon;
the plasma gun 14 is operable to remove impurities of the silicon
solution L in the silicon-stored bucket 12;
the inert gas introduction device 13 is configured in the
silicon-stored bucket 12;
the RH device 2 comprises a second degassing outlet 21 and a
connection pipe 22;
the connection pipe 22 is plugged into the silicon-stored bucket 12
through the joining opening 112;
the joining opening 112 is tightly sealed so that introduced inert gas
by the inert gas introduction device 13 moves towards the connection pipe 22; and
by vacuuming the VD device 1 and the RH device 2 through the first
and second degassing outlets 111 and 21, respectively, and by adjusting the degrees of vacuum of the VD device 1 and the RH device 2, the height of the liquid silicon solution L in the RH device 2 is controlled.

2. The vacuum recycling apparatus according to claim 1, wherein the VD device 1 is integrated with a furnace into a single device.

3. The vacuum recycling apparatus according to claim 1, wherein the silicon-stored bucket 12 is integrated into the VD device 1 as an integral chamber 12'.

4. The vacuum recycling apparatus according to claim 1, wherein the silicon-stored bucket 12 is integrated into the VD device as an integral chamber 12'; and the VD device 1 is further integrated with a furnace into a single device.

5. The vacuum recycling apparatus according to claim 2, wherein the furnace is a medium frequency furnace.

6. The vacuum recycling apparatus according to claim 1, wherein the degrees of the vacuum of the vacuum chamber 11 of the VD device 1 and the RH device 2 are between 0.1 to 0.9 atm, and between 0.001 to 1,000 Pa, respectively.

7. The vacuum recycling apparatus according to claim 1, wherein the RH device 2 further comprises a real-time measuring device 23 so as to measure and monitor the amount of impurities in the silicon solution L in the silicon-stored bucket 12.

8. A method of applying the vacuum recycling apparatus of claim 1 to refine solar grade polysilicon comprising the steps of:
(a) a liquefaction step liquefying and pouring silicon raw material into the silicon-stored bucket 12 until the silicon solution L has a level higher than the aperture of the connection pipe 22;
(b) a vacuuming step degassing the VD device 1 and the RH device 2 until their degrees of the vacuum are between 0.1 to 0.9 atm, and between 0.001 to 1,000 Pa, respectively;
(c) a stir step agitating the silicon solution L by introducing inert gas through the inert gas introduction device 13 and, as the inert gas moves towards the connection pipe 22, achieving diffusing and degassing effects;
(d) an impurity removal step removing impurities in the silicon solution L;
(e) a confirmation step disrupting the supply of the inert gas when the amount of phosphorous in the silicon solution L is less than 0.8 ppm, and reducing the degree of vacuum in the RH device 2 so that the silicon solution L flows back into the silicon-stored bucket 12; and
(f) a formation step pouring the silicon solution L processed by the above steps into a slow-condensing container, removing the less pure offcuts after cooling, crushing the solidified silicon, acid-cleaning for removing impurities, and casting into directional ingot.

9. The vacuum recycling apparatus according to claim 8, wherein the confirmation step disrupts the supply of the inert gas further requiring the amount of boron in the silicon solution L is less than 0.4 ppm; and, in the formation step, the solidified silicon solution is crushed into 50 to 150 meshes.

10. The method according to claim 8, wherein the impurity removal step uses at least a plasma gun 14 to remove impurities.

11. The vacuum recycling apparatus according to claim 4, wherein the furnace is a medium frequency furnace.

## Patentansprüche

1. Vakuumrecyclingapparat zur Veredelung von Solarsilizium, mit einer Vakuumentgasungsanlage (VD) 1 und einer Vakuumrecyclinganlage (RH) 2, wobei die VD-Anlage 1 eine Unterdruckkammer 11 umfasst, einen Eimer mit Silizium 12, eine Plasmakanone 14 und eine Edelgaseinführungsvorrichtung 13;
die Unterdruckkammer 11 umfasst einen ersten Entgasungsauslass 111 und eine Verbindungsöffnung 112;
der Eimer mit Silizium 12 wird in der Unterdruckkammer 11 und unterhalb der Verbindungsöffnung 112 positioniert, zum Speichern flüssiger Siliziumlösung L oder zum Speichern festen Siliziums;
die Plasmakanone 14 entfernt Unreinheiten der Siliziumlösung L in dem Eimer mit Silizium 12;
die Edelgaseinführungsvorrichtung 13 ist in dem Eimer mit Silizium 12 konfiguriert;
die Recyclinganlage 2 umfasst einen zweiten Entgasungsauslass 21 und ein Anschlussrohr 22;
das Anschlussrohr 22 wird durch die Verbindungsöffnung 112 in den Eimer mit Silizium 1 gesteckt;
die Verbindungsöffnung 112 wird fest abgedichtet, so dass durch die Edelgaseinführungsvorrichtung 13 eingegebenes Edelgas sich zu dem Anschlussrohr 22 hin bewegt; und
durch Vakuumieren der VD-Anlage 1 und der Recyclinganlage 2 durch den ersten bzw. zweiten Entgasungsausgang 111 und 21 und durch Einstellung des Grades von Vakuum der VD-Anlage 1 und der Recyclinganlage 2 wird die Höhe der flüssigen Siliziumlösung L in der Recyclinganlage 2 gesteuert.

2. Vakuumrecyclingapparat nach Anspruch 1, wobei die VD-Anlage 1 mit einem Ofen eine Einheit bildet.

3. Vakuumrecyclingapparat nach Anspruch 1, wobei der Eimer mit Silizium 12 als eingebaute Kammer 12' in die VD-Anlage 1 integriert ist.

4. Vakuumrecyclingapparat nach Anspruch 1, wobei der Eimer mit Silizium 12 als eingebaute Kammer 12' in die VD-Anlage integriert ist und die VD-Anlage 1 dazu mit einem Ofen eine Einheit bildet.

5. Vakuumrecyclingapparat nach Anspruch 2, wobei der Ofen ein Mittelfrequenzofen ist.

6. Vakuumrecyclingapparat nach Anspruch 1, wobei die Grade des Vakuums der Unterdruckkammer 11 der VD-Anlage 1 und der Recyclinganlage 2 0,1 bis 0,9 atm bzw. 0,001 bis 1,000 Pa betragen.

7. Vakuumrecyclingapparat nach Anspruch 1, wobei die Recyclinganlage 2 des weiteren eine Echtzeitmessvorrichtung 23 umfasst, um die Menge an Unreinheiten in der Siliziumlösung L in dem Eimer mit Silizium 12 zu messen und zu überwachen.

8. Verfahren zum Anwendung des Vakuumrecyclingapparats nach Anspruch 1 zur Veredelung von Solarsilizium mit folgenden Phasen:
(a) eine Verflüssigungsphase mit Verflüssigen und Gießen rohen Siliziums in den Eimer mit Silizium 12, bis die Höhe der Siliziumlösung L höher als die Öffnung des Anschlussrohrs 22 ist;
(b) eine Vakuumphase mit Entgasung der VD-Anlage 1 und der Recyclinganlage 2, bis ihr Grad des Vakuums 0,1 bis 0,9 atm bzw. 0,001 bis 1,000 Pa beträgt;
(c) eine Umrührphase mit Umrühren der Siliziumlösung L durch Einführung von Edelgas durch die Edelgaseinführungsvorrichtung 13 sowie Ausbreitungs- und Entgasungseffekten, während das Edelgas sich zu dem Anschlussrohr 22 hin bewegt;
(d) eine Unreinheitsentfernungsphase, die Unreinheiten in der Siliziumlösung L entfernt;
(e) eine Bestätigungsphase, die die Zufuhr des Edelgases unterbricht, wenn die Menge an Phosphor in der Siliziumlösung L weniger als 0,8 ppm ist, und den Vakuumgrad in der Recyclinganlage 2 reduziert, so dass die Siliziumlösung L zurück in den Eimer mit Silizium 12 fließt; und
(f) eine Bildungsphase mit Gießen der durch die obigen Phasen verarbeiteten Siliziumlösung L in einen langsam kondensierenden Behälter, Entfernung der weniger reinen Verschnitte nach der Kühlung, Zerkleinern des erstarrten Siliziums, Säurereinigung zum Entfernen von Unreinheiten und Gießen in Barren zur gerichteten Erstarrung.

9. Vakuumrecyclingapparat nach Anspruch 8, wobei die Bestätigungsphase die Zufuhr des Edelgases unterbricht und des weiteren erfordert, dass die Menge an Bor in der Siliziumlösung L weniger als 0,4 ppm beträgt; und in der Bildungsphase wird die erstarrte Siliziumlösung in Maschen à 50 bis 150 zerkleinert.

10. Verfahren nach Anspruch 8, wobei die Phase der Entfernung von Unreinheiten mindestens eine Plasmakanone 14 verwendet, um Unreinheiten zu entfernen.

11. Vakuumrecyclingapparat nach Anspruch 4, wobei der Ofen ein Mittelfrequenzofen ist.

## Revendications

1. Appareil de recyclage sous vide pour le raffinage de polysilicium de qualité solaire, comprenant un dispositif de dégazage sous vide (VD) 1 et un dispositif de recyclage sous vide (RH) 2, dans lequel
le dispositif VD 1 comprend une chambre à vide 11, un seau contenant du silicium 12, un canon à plasma 14 et un dispositif d'introduction de gaz inerte 13;
la chambre à vide 11 comprend une première sortie de dégazage 111 et une ouverture de couplage 112;
le seau contenant du silicium 12 est positionné dans la chambre à vide 11 et au-dessous de l'ouverture de couplage 112 afin de stocker la solution de silicium liquide L ou de stocker du silicium solide;
le canon à plasma 14 est utilisé pour éliminer les impuretés de la solution de silicium L dans le seau contenant du silicium 12;
le dispositif d'introduction de gaz inerte 13 est configuré dans le seau contenant du silicium 12;
le dispositif de recyclage sous vide RH 2 comprend une deuxième sortie de dégazage 21 et un tuyau de connexion 22;
le tuyau de connexion 22 est raccordé au seau contenant du silicium 12 à travers l'ouverture de couplage 112;
l'ouverture de couplage 112 est scellée hermétiquement de telle sorte que le gaz inerte introduit par le dispositif d'introduction de gaz inerte 13 se déplace vers le tuyau de connexion 22; et moyennant la disposition du dispositif VD 1 et du dispositif RH 2 sous vide à travers les première et deuxième sorties de dégazage 111 et 21, respectivement, et le réglage des degrés de vide du dispositif VD 1 et du dispositif RH 2, il est possible de contrôler la hauteur de la solution de silicium liquide L dans le dispositif RH 2.

2. Appareil de recyclage sous vide selon la revendication 1, où le dispositif VD 1 est partie intégrante d'un four formant un seul dispositif.

3. Appareil de recyclage sous vide selon la revendication 1, où le seau contenant du silicium 12 s'intègre dans le dispositif VD 1 en forme de chambre intégrée 12'.

4. Appareil de recyclage sous vide selon la revendication 1, où le seau contenant du silicium 12 s'intègre dans le dispositif VD en forme de chambre intégrée 12'; et le dispositif VD 1 fait également partie intégrante d'un four dans un seul dispositif.

5. Appareil de recyclage sous vide selon la revendication 2, où le four est un four à fréquence moyenne.

6. Appareil de recyclage sous vide selon la revendication 1, où les degrés de vide de la chambre à vide 11 du dispositif VD 1 et du dispositif RH 2 sont compris entre 0,1 et 0,9 atm, et entre 0,001 et 1,000 Pa, respectivement.

7. Appareil de recyclage sous vide selon la revendication 1, où le dispositif de recyclage sous vide 2 comprend en outre un dispositif de mesure en temps réel 23 destiné à mesurer et à contrôler la quantité d'impuretés dans la solution de silicium L dans le seau contenant du silicium 12.

8. Méthode d'application de l'appareil de recyclage sous vide de la revendication 1 pour le raffinage de polysilicium de qualité solaire comprenant les étapes suivantes:
(a) une étape de liquéfaction afin de liquéfier et de verser du silicium brut dans le seau contenant du silicium 12 jusqu'à ce que la solution de silicium L atteigne un niveau supérieur par rapport à l'ouverture du tuyau de connexion 22;
(b) une étape de mise à vide pour le dégazage du dispositif VD 1 et du dispositif RH 2 jusqu'à ce que leurs degrés de vide soient compris entre 0,1 à 0,9 atm, et entre 0,001 à 1,000 Pa, respectivement;
(c) une étape d'agitation pour agiter la solution de silicium L en introduisant du gaz inerte à travers le dispositif d'introduction de gaz inerte 13 et, à mesure que le gaz inerte se déplace vers le tuyau de connexion 22, afin d'obtenir les effets de diffusion et de dégazage;
(d) une étape d'élimination des impuretés pour éliminer les impuretés dans la solution de silicium L;
(e) une étape de confirmation qui interrompt l'alimentation du gaz inerte lorsque la quantité de phosphore dans la solution de silicium L est inférieure à 0.8 ppm, et qui réduit le degré de vide dans le dispositif RH 2 de telle sorte que la solution de silicium L retourne dans le seau contenant du silicium 12; et
(f) une étape de formation pour verser la solution de silicium L traitée pendant les étapes citées antérieurement dans un récipient à condensation lente, afin d'éliminer les résidus moins purs après refroidissement, broyage du silicium solidifié, nettoyage à l'acide pour éliminer les impuretés, et moulage en lingot directionnel.

9. Appareil de recyclage sous vide selon la revendication 8, où l'étape de confirmation interrompt l'alimentation du gaz inerte, tout en exigeant en outre que la quantité de bore dans la solution de silicium L soit inférieure à 0.4 ppm; et, pendant l'étape de formation, la solution de silicium solidifié est broyée en pièces de format 50 à 150.

10. Méthode selon la revendication 8, où l'on utilise au moins un canon à plasma 14 pendant l'étape d'élimination des impuretés afin d'éliminer les impuretés.

11. Appareil de recyclage sous vide selon la revendication 4, où le four est un four à fréquence moyenne.
